(19) Europäisches Patentamt
European Patent Office
Office européen des brevets

(11) **EP 1 588 176 B1**

(12) **EUROPÄISCHE PATENTSCHRIFT**

(45) Veröffentlichungstag und Bekanntmachung des Hinweises auf die Patenterteilung:
**23.12.2009 Patentblatt 2009/52**

(21) Anmeldenummer: **03753325.4**

(22) Anmeldetag: **29.09.2003**

(51) Int Cl.:
**G01R 31/36** (2006.01)

(86) Internationale Anmeldenummer:
**PCT/DE2003/003232**

(87) Internationale Veröffentlichungsnummer:
**WO 2004/070407 (19.08.2004 Gazette 2004/34)**

(54) **VERFAHREN UND VORRICHTUNG ZUM ERMITTELN DER AUS EINEM ENERGIESPEICHER ENTNEHMBAREN LADUNG**

METHOD AND DEVICE FOR DETERMINING THE CHARGE THAT CAN BE DRAWN FROM AN ENERGY ACCUMULATOR

PROCEDE ET DISPOSITIF POUR DETERMINER LA CHARGE POUVANT ETRE PRELEVEE D'UN ACCUMULATEUR D'ENERGIE

(84) Benannte Vertragsstaaten:
**AT BE BG CH CY CZ DE DK EE ES FI FR GB GR HU IE IT LI LU MC NL PT RO SE SI SK TR**

(30) Priorität: **20.01.2003 DE 10301823**

(43) Veröffentlichungstag der Anmeldung:
**26.10.2005 Patentblatt 2005/43**

(73) Patentinhaber: **ROBERT BOSCH GMBH**
**70442 Stuttgart (DE)**

(72) Erfinder: **SCHOCH, Eberhard**
**70469 Stuttgart (DE)**

(56) Entgegenhaltungen:
**EP-A- 0 420 530     WO-A-89/01169**
**WO-A-90/13823     DE-A- 10 203 810**

• **PILLER S ET AL: "Methods for state-of-charge determination and their applications" JOURNAL OF POWER SOURCES, ELSEVIER SEQUOIA S.A. LAUSANNE, CH, Bd. 96, Nr. 1, 1. Juni 2001 (2001-06-01), Seiten 113-120, XP004298736 ISSN: 0378-7753**

EP 1 588 176 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft eine Vorrichtung zum Ermitteln der aus einem Energiespeicher, insbesondere einer Batterie, bis zu einem vorgegebenen Entladeschluss entnehmbaren Ladung gemäss dem Oberbegriff des Patentanspruchs 1 sowie ein entsprechendes Verfahren gemäss dem Oberbegriff des Patentanspruchs 9.

Bei elektrischen Energiespeichern, wie z.B. Batterien, ist die aktuell entnehmbare Ladung eine wichtige Grösse, da sie Ausdruck für die noch verfügbare Energiereserve bis zum Unterschreiten einer vom Energiespeicher geforderten Mindestleistungsfähigkeit ist. Gerade auf dem Gebiet der Automobiltechnik ist eine genaue Vorhersage der entnehmbaren Ladung entscheidender als die Kenntnis des aktuellen, über die mittlere Säurekonzentration im Bleiakkumulator definierten, Ladezustands der Batterie, da dieser nur eine Information über die bereits entnommene Ladung gegenüber Vollladung liefert, nicht jedoch über die noch entnehmbare Ladungsmenge.

Die gesamte noch entnehmbare Ladung bestimmt unmittelbar die Verfügbarkeit der am Energiespeicher angeschlossenen elektrischen Verbraucher. Die Kenntnis der entnehmbaren Ladung kann außerdem für steuer- oder regelungstechnische Massnahmen, wie z.B. für ein Energiemanagement in einem Fahrzeug, genutzt werden. Dadurch wird es z.B. möglich, rechtzeitig vor Erreichen einer Mindestladungsreserve verbrauchsmindernde Maßnahmen, wie z.B. das Abschalten oder Dimmen weniger wichtiger Verbraucher, einzuleiten.

Aus der EP-0376967 B1 ist es bereits bekannt, die aus einem Energiespeicher entnehmbare Ladung zu bestimmen. Dabei wird die entnehmbare Ladung über empirisch ermittelte Kennlinienfelder, die in einer Recheneinheit hinterlegt sind, in Abhängigkeit eines konstanten Entladestromes, der Batterietemperatur und von Alterungserscheinungen auf Grundlage der Peukert-Formel abgeschätzt. Dadurch ist es zwar möglich, die entnehmbare Ladung bis zu einem Entladeschluss zu ermitteln, der durch das vollständige Entladen des Energiespeichers gekennzeichnet ist, dagegen ist es nicht möglich, die entnehmbare Ladung bis zum Unterschreiten einer vorgegebenen Mindest-Klemmenspannung oder bis zum Unterschreiten einer Mindest-Leistungsfähigkeit des Energiespeichers zu bestimmen. Darüber hinaus ist die Bestimmung der entnehmbaren Ladung auf Grundlage der Peukert-Formel relativ ungenau, da verschiedene Effekte, die den Zustand des Entladeschlusses beeinflussen, wie z.B. ein Aktivmasseverlust an den Elektroden durch Batteriealterung oder die Eisbildung an den Elektroden bei niedrigen Temperaturen, nicht berücksichtigt werden.

Aus der WO 90/13823 sind ein Verfahren und eine Vorrichtung zur Bestimmung von physikalischen Größen von wiederaufladbaren elektrischen Energiespeichern bekannt. Hierbei werden Prozesseingangsgrößen des Energiespeichers gemessen und in einem Rechner verarbeitet, wobei nach dem bekannten Prinzip des indirekten Messens ein vorgebbares Modell, in Form geschlossener linearer oder nicht linearer mehrparametriger Funktionen und/oder eine heuristische Parametrierung als Schätzung, der (die) zu bestimmenden physikalischen Größen und ihre physikalischen Beziehungen zueinander repräsentiert, mit den gemessenen Prozesseingangsgrößen verglichen werden und für die nachfolgende Messung das Modell und/oder die Schätzung adaptiert wird. Hierbei wird die tatsächliche verfügbare Ladungsmenge unter Verwendung des differenziellen Ladewirkungsgrads aus der eingelagerten Ladungsmenge bilanziert.

DE 102 03 810 A1 offenbart ein Verfahren zur Ermittlung des Ladezustands und/oder der Leistungsfähigkeit eines Ladungsspeichers. Hierbei wird die aktuelle Leistungsfähigkeit der Batterie über die Spannungsantwort eines mit dem Zustandsvektor und dem Parametervektor initialisierten Batteriemodels auf ein vorgegebenes Laststromprofil beurteilt. Hierbei steht insbesondere die Abschätzung der Leistungsfähigkeit bei kurzzeitiger Belastung, beispielsweise in der Größenordnung von 10 Sekunden mit Strömen in der Größenordnung ≤ 100 A im Vordergrund

In dem Artikel "Methods for state-of-charge determination and their applications", S. Piller, M.Perrin, A.Jossen in Journal of Power Sources 96 (2001) Seite 113-120 wird eine Ladezustandsermittlung vorgestellt, die auf bestimmte Batteriemodelle für dynamische Anwendungen zurückgreift. Ein Entladungsprädiktor, der die entnehmbare Ladung bis zum Erreichen eines vorgegebenen Entladeschlusskriteriums ermittelt, ist jedoch nicht vorgesehen.

Aus der EP 420 530 A1 sind eine Vorrichtung und ein Verfahren zur adaptiven Vorhersage der verbleibenden Batterieentladezeit bekannt. Der Algorithmus zur Ladezustandserfassung basiert auf gemessenen Entladecharakteristiken der Batterien, deren verbleibende Entladezeit vorherzusagen ist. Diese Entladecharakteristika wurden auf zwei Parameter reduziert, welche nicht abhängen vom Ladestrom.

Es ist daher die Aufgabe der vorliegenden Erfindung, eine Vorrichtung sowie ein Verfahren zum Ermitteln der aus einem Energiespeicher entnehmbaren Ladung zu schaffen, die bzw. das eine sehr genaue Bestimmung der entnehmbaren Ladung bis zu einem vorgegebenen Entladeschlusskriterium ermöglicht.

Gelöst wird diese Aufgabe gemäss der Erfindung durch die im Patentanspruch 1 bzw. 9 angegebenen Merkmale. Weitere Ausgestaltungen der Erfindung sind Gegenstand von Unteransprüchen.

Der wesentliche Gedanke der Erfindung besteht darin, einen Ladungsprädiktor, d.h. eine Einrichtung zur Berechnung der entnehmbaren Ladung, vorzusehen, der die aus dem Energiespeicher entnehmbare Ladung unter Berücksichtigung eines vorgegebenen Entladestromverlaufs und Temperaturverlaufs mit Hilfe eines mathematischen Energiespeichermodells berechnet. Das Energiespeichermodell ist dabei ein mathematisches Modell, das die auf verschiedenen physikalischen Effekten beruhenden elektrischen Eigenschaften des Energiespeichers anhand verschiedener mathematischer Modelle darstellt. Die mathematischen Modelle beschreiben funktionale Zusammenhänge zwischen Zustandsgrößen, wie beispielsweise Spannungen, Strömen, Temperatur etc., und umfassen verschiedene Parameter.

Die vom Ladungsprädiktor durchgeführte Ladungsberechnung erfolgt ausgehend vom aktuellen Zustand des Energiespeichers. Die im Ladungsprädiktor hinterlegten mathematischen Modelle werden daher zunächst auf den aktuellen Betriebszustand des Energiespeichers initialisiert. Hierzu ist ein Zustandsgrößen- und Parameterschätzer vorgesehen, der aus den aktuellen Betriebsgrößen, wie beispielsweise der Spannung, dem Strom und der Temperatur des Energiespeichers, die Zustandsgrößen und gegebenenfalls auch Parameter des Energiespeichermodells ermittelt. Für diejenigen Zustandsgrößen des Energiespeichers, die während des Betriebs nicht direkt gemessen werden können, kann beispielsweise ein bekannter Kalman-Filter als Zustandsgrößen- und Parameterschätzer verwendet werden. Ausgehend von diesem Initialisierungszustand errechnet der Ladungsprädiktor dann die aus dem Energiespeicher entnehmbare Ladung bis zu einem vorgegebenen Entladeschluss, d.h. bis zu einem oder mehreren vorgegebenen Entladeschlussk-riterien, die nachstehend noch ausführlich erläutert werden.

Das Energiespeichermodell umfasst im Falle einer Batterie wenigstens ein Modell für den Innenwiderstand $R_i$ der Batterie, einen Säurediffusionswiderstand $R_k$ und eine Durchtrittspolarisation $U_D$.

Der Zustands- und Parameterschätzer ermittelt als Zustandsgrößen Z zumindest eine Ruhespannung $U_{C0}$ der Batterie und eine Konzentrationspolarisation $U_k$. Sofern die Batteriekapazität und damit auch die Säurekapazität $C_0$ der verwendeten Batterie unbekannt ist, ist auch diese zu berechnen. Hierzu ermittelt der Zustandsgrößen- und Parameterschätzer vorzugsweise zumindest die Parameter $R_{i025}$, $U_{e, grenz}$, $R_{k025}$, $U_{D025}$ und $C_0$. Diese Parameter werden im folgenden noch ausführlich erläutert.

Das Entladeschlusskriterium, bis zu dem die entnehmbare Ladung berechnet wird, kann beispielsweise das Erreichen bzw. Unterschreiten einer vorgegebenen minimalen Elektrolytspannung $U_{ekrit}$, einer minimalen Klemmenspannung $U_{Battmin}$ oder das Erreichen einer vorgegebenen Mindestleistungsfähigkeit $U_{Lastmin}$ sein. Gemäss einer bevorzugten Ausführungsform der Erfindung wird die entnehmbare Ladung bis zum Erreichen bzw. Unterschreiten von wenigstens zwei, vorzugsweise aller drei, der genannten Entladeschlusskriterien berechnet.

Das Entladeschlusskriterium der minimalen Elektrolytspannung $U_{ekrit}$ ist erfüllt, wenn die Elektrolytspannung $U_e$ unter die vorgegebene minimale Elektrolytspannung $U_{ekrit}$ fällt. Die vorgegebene Elektrolytspannung $U_{ekrit}$ berücksichtigt dabei vorzugsweise den Aktivmasseverlust durch Batteriealterung und/oder die Eisbildung an den Elektroden bei niedrigen Temperaturen.

Das Entladeschlusskriterium der minimalen Klemmenspannung $U_{Battmin}$ ist erfüllt, wenn die Klemmenspannung $U_{Batt}$ unter die vorgegebene minimale Klemmenspannung $U_{Battmin}$ fällt.

Das Kriterium der Mindestleistungsfähigkeit ist dann erreicht, wenn eine Netzspannung, wie z.B. die Spannung an einer vom Energiespeicher versorgten Last, unter einen vorgegebenen Schwellenwert sinken würde, wenn der Energiespeicher über eine vorgegebene Zeitdauer mit der Last belastet werden würde. Um festzustellen, ob die Lastspannung bei einem vorgegebenen Laststromverlauf unter einen vorgegebenen Schwellenwert sinken würde, ist ein Spannungsprädiktor vorgesehen, der in Abhängigkeit vom Laststromverlauf die zugehörige Lastspannung ermittelt. In einem Kraftfahrzeug kann somit ermittelt werden, wieviel Ladung noch aus der Kraftfahrzeugbatterie bei einem vorgegebenen Entladestrom- und Batterietemperaturverlauf entnehmbar ist, bis nur noch soviel Ladung enthalten ist, dass die Netzspannung an einer zuzuschaltenden Last, bei vorgegebenem Laststromverlauf , nicht unter einen vorgegebenen Schwellenwert fällt. Dies ist im Falle eines Kfz-Bordnetzes vor allem notwendig, um zu verhindern, dass nicht mehr Ladung aus der Batterie entnommen wird, wie z.B. für einen erneuten Startvorgang benötigt wird.

Wahlweise können auch andere Entladeschlusskriterien definiert werden.

Die Ermittlung der aus dem Energiespeicher entnehmbaren Ladung wird in vorgegebenen zeitlichen Abständen vom Ladungsprädiktor wiederholt, wobei jeweils aktuelle Werte für den Entladestrom $I_{Batt, entl}$ und die Energiespeichertemperatur $T_{Batt, entl}$ berücksichtigt werden. Der Ladungsprädiktor ist vorzugsweise auch in der Lage, die Zeit bis zum Erreichen des vorgegebenen Entladeschlusskriteriums zu bestimmen.

Der Zustands- und Parameterschätzer arbeitet vorzugsweise auf der Grundlage des gleichen Energiespeichermodells wie der Ladungsprädiktor.

Die Erfindung wird nachstehend anhand der beigefügten Zeichnungen beispielhaft näher erläutert. Es zeigen:

Fig. 1 eine schematische Darstellung einer Vorrichtung zum Ermitteln der aus einer Batterie entnehmbaren Ladung, mit einem Ladungsprädiktor und einem Spannungsprädiktor;

Fig. 2 ein Ersatzschaltbild für einen Bleiakkumulator;

Fig. 3a ein Flussdiagramm zur Darstellung der wesentlichen Verfahrensschritte bei der Berechnung der entnehmbaren Ladung durch einen Ladungsprädiktor;

Fig. 3b,c ein Flussdiagramm zur Darstellung der Überprüfung verschiedener Entladeschlusskriterien;

Fig. 3d ein Flussdiagramm zur Darstellung der wesentlichen Verfahrensschritte bei der Berechnung einer minimalen Batteriespannung durch einen Spannungsprädiktor; und

Fig. 4 eine Darstellung der Abhängigkeit der Elektrolytspannung von verschiedenen physikalischen Effekten.

### 1. Vorrichtung zur Ermittlung der entnehmbaren Ladung

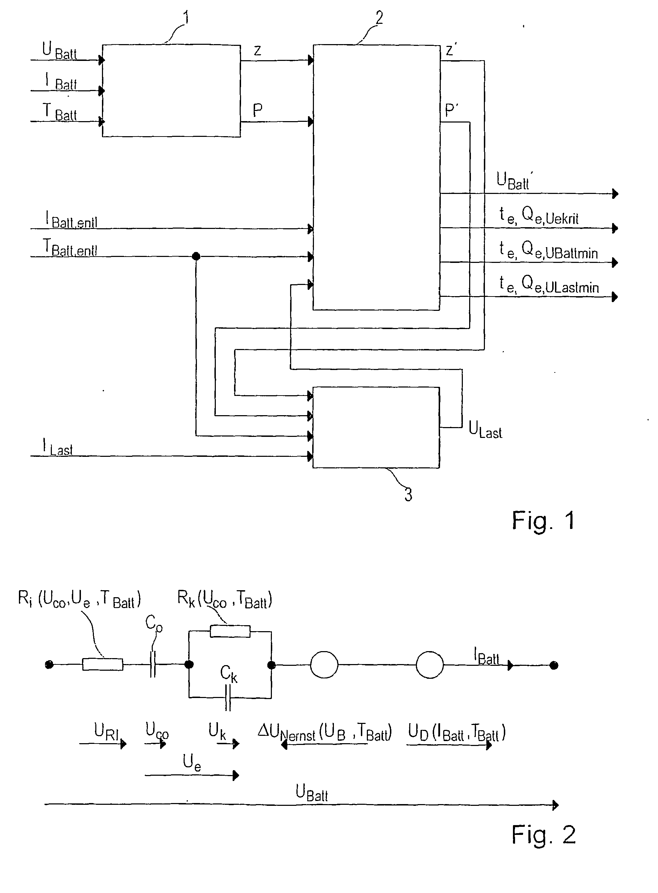

Fig. 1 zeigt ein Blockschaltbild einer Vorrichtung zur Berechnung der aus einer Batterie, insbesondere einer Fahrzeugbatterie, entnehmbaren Ladung. Diese umfasst einen Zustandsgrößen- und Parameterschätzer 1, einen Ladungsprädiktor 2 und einen Spannungsprädiktor 3. Die Vorrichtung ist in der Lage, die aus der Batterie (nicht gezeigt) entnehmbare Ladung, ausgehend von einem aktuellen Batteriezustand $U_{Batt}$, $I_{Batt}$, $T_{Batt}$ und einem vorgegebenen Entladestromverlauf $I_{Batt,entl}$, bis zum Erreichen eines vorgegebenen Entladeschlusses zu berechnen. Der Entladestromverlauf $I_{Batt,entl}$ kann dabei ein beliebig vorgegebener Stromverlauf oder ein konstanter Strom ($I_{Batt}$) sein.

Der Ladungsprädiktor 2 und der Spannungsprädiktor 3 umfassen ein mathematisches Batteriemodell, welches die elektrischen Eigenschaften der Fahrzeugbatterie beschreibt. Bei Kenntnis der aktuellen Betriebsgrößen der Batterie, nämlich der aktuellen Batteriespannung $U_{Batt}$, des aktuellen Batteriestroms $I_{Batt}$ und der aktuellen Batterietemperatur $T_{Batt}$, sowie unter Berücksichtigung eines vorgegebenen Entladestromverlaufs $I_{Batt,entl}$ und eines vorgegebenen Temperaturverlaufs $T_{Batt,\ entl}$ kann somit die aus der Batterie entnehmbare Ladung $Q_{e,Ukrit}$, $Q_{e,UBattmim}$, $Q_{e,ULastmin}$ bis zum Erreichen dreier unterschiedlicher Entladeschlusskriterien (die im vorliegenden Beispiel konjunktiv verknüpft sind) berechnet werden. Der Entladestromverlauf $I_{Batt,entl}$ und der Temperaturverlauf $T_{Batt,entl}$ während der Entladung können entweder von einem Steuergerät (nicht gezeigt) vorgegeben oder aus den aktuellen Betriebsgrößen der Batterie $U_{Batt}$, $I_{Batt}$, $T_{Batt}$ ermittelt werden.

Der Ladungsprädiktor 2 und der Spannungsprädiktor 3 umfassen ein mathematisches Batteriemodell, das die elektrischen Eigenschaften der Fahrzeugbatterie mathematisch beschreibt und das auf dem in Fig. 2 gezeigten Ersatzschaltbild für einen Bleiakkumulator beruht.

### 2. Ersatzschaltbild eines Bleiakkumulators

Fig. 2 zeigt das Ersatzschaltbild eines Bleiakkumulators. Die Zählrichtung des Batteriestroms $I_{Batt}$ wurde wie üblich positiv für Laden und negativ für Entladen gewählt. Die einzelnen Zustandsgrößen und Komponenten sind wie folgt, von links nach rechts:

| | |
|---|---|
| $R_1$ ($U_{C0}$, $U_e$, $T_{Batt}$) | ohmscher Innenwiderstand, abhängig von der Ruhespannung $U_{C0}$, der Elektrolytspannung $U_e$ und der Säuretemperatur $T_{Batt}$ |
| $U_{Ri}$ | ohmscher Spannungsabfall |
| $C_0$ | Säurekapazität |
| $U_{C0}$ | Ruhespannung |
| $R_k$ ($U_{C0}/T_{Batt}$) | Säurediffusionswiderstand, abhängig von der Ruhespannung $U_{C0}$ (Entladegrad) und der Säuretemperatur $T_{Batt}$ |
| $\tau_k = R_k {}^* C_k$ | Zeitkonstante der Säurediffusion (wird als konstant in der Größenordnung von 10 min angenommen) |
| $u_k$ | Konzentrationspolarisation |
| $U_e = U_{C0} + U_k$ | Elektrolytspannung |
| $\Delta U_{Nernst}$ ($U_e$, $T_{Batt}$) | Spannungsdifferenz zwischen der Klemmenspannung und der Elektrolytspannung $U_e$, abhängig von der Elektrolytspannung $U_e$ und der Säuretemperatur $T_{Batt}$ |
| $U_D$ ($I_{Batt}$, $T_{Batt}$) | stationäre Durchtrittspolarisation, abhängig vom Batteriestrom $I_{Batt}$ und der Säuretemperatur $T_{Batt}$ |
| $U_{Batt}$ | Klemmenspannung der Batterie |

Die einzelnen Größen sind zurückzuführen auf verschiedene physikalische Effekte der Batterie, die im folgenden kurz erläutert werden:

Die Spannung $U_{Ri}$ ist der ohmsche Spannungsabfall am Innenwiderstand $R_i$ der Batterie, der wiederum von der Ruhespannung $U_{C0}$, der Elektrolytspannung $U_e$ und der Säuretemperatur $T_{Batt}$ abhängt.

Die Ruhespannung $U_{C0}$ ist proportional zur mittleren Säurekonzentration in der Batterie und ist gleich der Klemmenspannung der Batterie, wenn die Säurekonzentration nach einer Ruhephase der Batterie überall gleich groß ist.

Die Konzentrationspolarisation $U_k$ berücksichtigt die Abweichung der Säurekonzentration am Reaktionsort, d.h. den Elektroden, vom Mittelwert in der Batterie. Bei der Batterieentladung besteht die niedrigste Säurekonzentration in den Poren der Elektroden, da die Säure dort verbraucht wird und neue Säure erst aus dem Elektrolyt nachfließen muss.

Die Elektrolytspannung $U_e$ berücksichtigt die Abweichung der Ruhespannung $U_{C0}$ durch die Konzentrations-

**EP 1 588 176 B1**

polarisation in Abhängigkeit von der Säurekonzentration am Reaktionsort. Dabei gilt $U_e = U_{C0} + U_k$.

Der Term $\Delta U_{Nernst}(U_e, T_{Batt})$ beschreibt die Spannungsdifferenz zwischen dem Elektrodenpotential und der Elektrolytspannung, die wiederum abhängig ist Von der lokalen Säurekonzentration am Reaktionsort, und von der Säuretemperatur $T_{Batt}$.

Die stationäre Durchtrittspolarisation $U_D(I_{Batt}, T_{Batt})$ berücksichtigt einen elektrischen Übergangswiderstand zwischen einer ersten Elektrode der Batterie und dem Elektrolyt und zwischen dem Elektrolyt und der zweiten Elektrode der Batterie und ist wiederum abhängig vom Batteriestrom $I_{Batt}$ und der Säuretemperatur $T_{Batt}$.

Die Diffusion der Säure aus dem Elektrolyt zum Reaktionsort, d.h. zu den Elektroden, während der Entladung, wird durch den Säurediffusionswiderstand $R_k(U_{C0}, T_{Batt})$ beschrieben, der wiederum abhängig ist von der Ruhespannung $U_{C0}$ und der Säuretemperatur $T_{Batt}$.

3. Das mathematische Energiespeichermodell

Das mathematische Energiespeichermodell umfasst mehrere Modelle, die den ohmschen Innenwiderstand der Batterie $R_1(U_{C0}, U_e, T_{Batt})$, den Säurediffusionswiderstand $R_k(U_{C0}, T_{Batt})$, die Spannungsdifferenz $\Delta U_{Nernst}(U_e, T_{Batt})$ zwischen dem Elektrodenpotential und der Elektrolytspannung und die stationäre Durchtrittspolarisation $U_D(I_{Batt}, T_{Batt})$ beschreiben. Wahlweise können auch mehr oder weniger mathematische Modelle berücksichtigt werden. Für die einzelnen im folgenden aufgeführten Größen können auch andere mathematische Modelle angesetzt werden.

3.1. Ohmscher Innenwiderstand:

$$R_i(U_{C0}, U_e, T_{Batt}) = R_{i0}(T_{Batt}) * (1 + R_{i,fakt} * (U_{C0max} - U_{C0}) / (U_e - U_{e,grenz})),$$

mit

$$R_{i0}(T_{Batt}) = R_{i025} / (1 + TK_{Lfakt} * (T_{Batt} - 25°C))$$

Dabei sind:

$R_{i025}$     ohmscher Innenwiderstand bei Vollladung und $T_{Batt}=25°C$
$TK_{Lfakt}$     Temperaturkoeffizient des Batterieleitwerts
$R_i, f_{akt}$     Kennfeldparameter
$U_{C0max:}$     Maximale Ruhespannung der vollgeladenen Batterie
$U_{e,grenz}$     Elektrolytspannung bei Entladeschluss (alterungsabhängig)

3.2. Säurediffusionswiderstand

Zur Approximation des Säurediffusionswiderstandes $R_k$ kann z.B. folgendes Modell angesetzt werden:

$$R_k(U_{C0}, T_{Batt}) = R_{k0}(T_{Batt}) * (1 + R_{k,fakt1} * (U_{C0max} - U_{C0}) + R_{k,fakt2} * (U_{C0max} - U_{C0})^2 + R_{k,fakt3} * (U_{C0max} - U_{C0})^3)$$

mit

5

$$R_{k0}(T_{Batt}) = R_{k025}*exp(-(E_{Rk0}/J)/8,314*(1/(273,15+T_{Batt}/°C) - 1/298,15))\ (Arrhenius-Ansatz)$$

und

$kk_{025}$            Säuredif fusionswiderstand bei Vollladung und $T_{Batt}$ = 25°C
$E_{rk0}$            Aktivierungsenergie
$P_{k, fakt1}$, $R_{k, fakt2}$, $R_{k, fakt3}$    Polynom-Koeffizienten

### 3.3 Spannungsdifferenz $\Delta U_{Nernst}$ zwischen dem Elektrodenpotential und der Elektrolytspannung $U_e$

Für die Spannungsdifferenz zwischen dem Elektrodenpotential und der Elektrolytspannung kann beispielsweise folgendes Modell angesetzt werden:

$$\Delta U_{Nernst}(U_e, T_{Batt}) = alpha*exp(-(U_e-U_{ekn})/beta)+TK_{U00}*(T_{Batt}-25°C);$$

mit

alpha, beta, $U_{ekn}$      Kennlinienparameter
$TK_{U00}$             Temperaturkoeffizient des Elektrodenpoten- tials

### 3.4. Stationäre Durchtrittspolarisation

Für die stationäre Durchtrittspolarisation $U_D$ kann folgendes Modell angesetzt werden:

$$U_D(I_{Batt}, T_{Batt}) = U_{D0}(T_{Batt})*ln(I_{Batt}/I_{D0}),$$

mit

$$U_{D0}(T_{Batt}) = U_{D025}*(1+TK_{UD01}*(T_{Batt}-25°C)+TK_{UD02}*(T_{Batt}-25°C)^2+TK_{UD03}*(T_{Batt}-25°C)^3)$$

$U_{D025}$            stationäre Durchtrittsspannung bei $I_{Batt}$=e*$I_{D0}$ und $T_{Batt}$=25°C

$I_{D0}$            Durchtrittsstrom für $U_D$=0V

$TK_{UD01}$ TKUD02, $TK_{UD02}$    Temperaturkoeffizienten erster, zweiter und dritter Ordnung der Durchtrittspolarisation

### 3.5. Einfluss der Säureschichtung in der Batterie

Eine Säureschichtung wird insbesondere bei Bleibatterien mit flüssigem Elektrolyt aufgebaut, wenn die Batterie ausgehend von einem niedrigen Ladezustand, d.h. niedriger mittlerer Säurekonzentration, mit hohem Strom geladen wird. Durch den hohen Ladestrom bildet sich im Bereich der Elektroden (Reaktionsort) Säure hoher Konzentration, die wegen ihres höheren spezifischen Gewichts nach unten absinkt, so dass im oberen Bereich die Säure niedriger Konzentration zurückbleibt. Die Batterie verhält sich bei Säureschichtung dadurch wie eine Batterie mit verringerter Kapazität (und somit verringerter entnehmbarer Ladung), da nur noch der untere Batteriebereich mit hoher Säurekonzentration an der Reaktion teilnimmt. Außerdem wird das Elektrodenpotential durch die erhöhte Säurekonzentration im unteren Bereich über den Wert einer ungeschichteten Batterie angehoben. Da die Ruhespannung $U_{C0}$ und Säurekapazität $C_0$ vom Zustandsgrößen- u. Parameterschätzer 1 ermittelt und adaptiert werden, wird auch die Auswirkung der Säureschichtung auf die entnehmbare Ladung bei der Ladungsprädiktion durch den Ladungsprädiktor 2 bereits implizit berücksichtigt. Das Verfahren berücksichtigt somit auch die Verringerung der entnehmbaren Ladung bei Batterien mit Säureschichtung.

4. Berechnung der aus dem Energiespeicher entnehmbaren Ladung

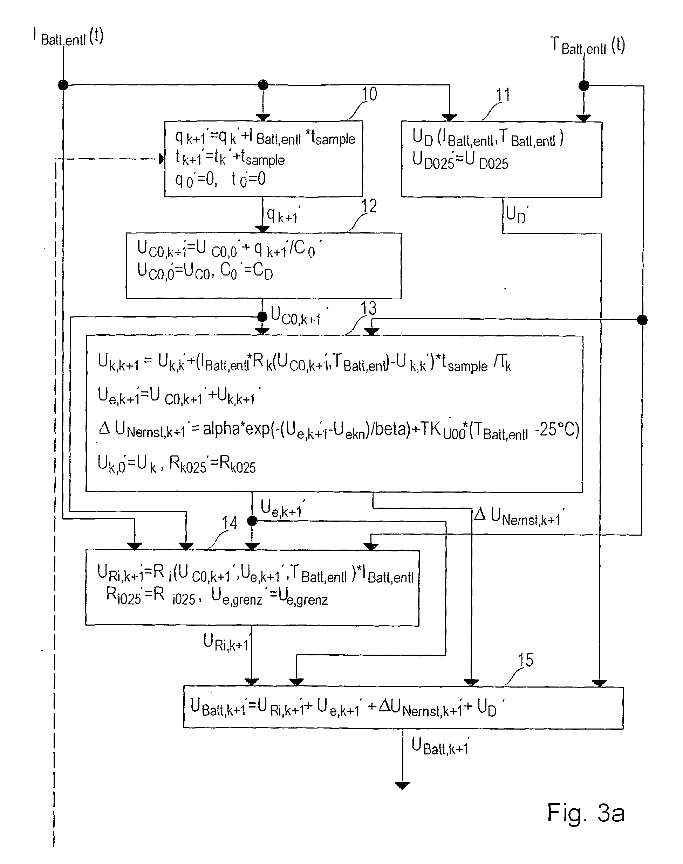

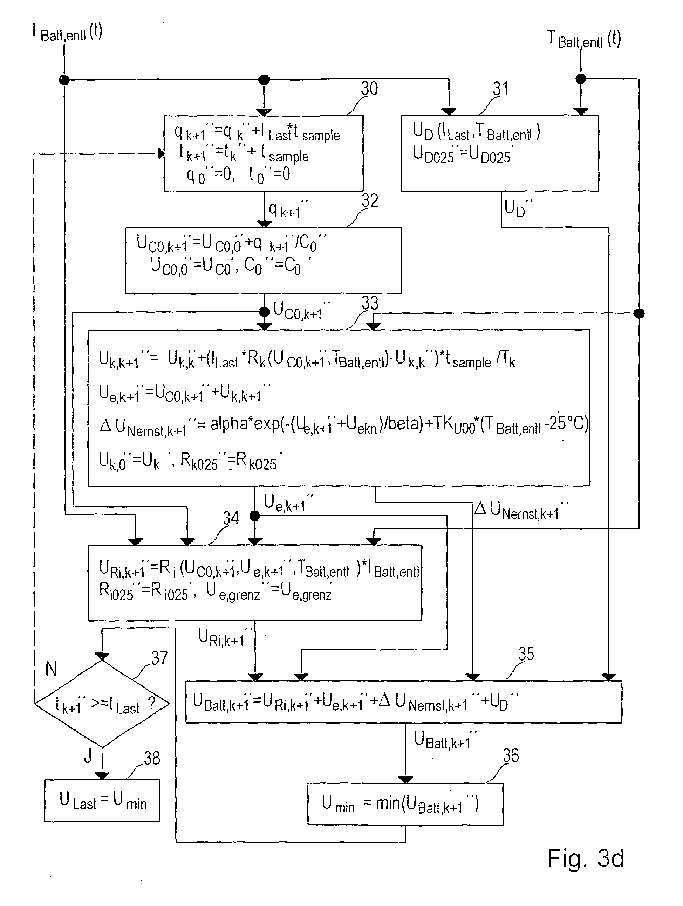

Fig. 3a zeigt die Berechnung der aus einer Fahrzeugbatterie entnehmbaren Ladung $Q_e$. Der Ladungsprädiktor 2 führt hierzu eine numerische Berechnung durch und ermittelt die Zustandsgrößen $U_{C0}$, $U_k$, $U_e$, $\Delta U_{Nernst}$, $U_{Ri}$ und $U_{Batt}$ des Batteriemodells von Fig. 2. Im einzelnen wird die Berechnung wie folgt durchgeführt:

In Block 10 wird die in einem Zeitschritt $t_{sample}$ aus der Batterie entnommene Ladung $q_k$ bei einem angenom-menen Entladestromverlauf $I_{Batt,entl}$ berechnet und iterativ addiert. Der Entladestromverlauf $I_{Batt, entl}$ kann z.B. konstant sein und dem Batteriestrom $I_{Batt}$ entsprechen oder ein beliebiger vorgegebener Stromverlauf sein. Es gilt:

$$q_{k+1}' \; = \; q_k' + I_{Batt,entl} * t_{sample}$$

$$t_{k+1}' \; = \; t_k' + t_{sample}$$

Die Startwerte $q_0'$ und $t_0'$ für diese Berechnung sind dabei:

$$q_0' \; = \; 0, \; t_0' \; = \; 0$$

Diese iterative Berechnung wird solange durchgeführt, bis ein vorgegebenes Entladeschlusskriterium erfüllt ist. Die aus der Batterie entnehmbare Ladung ist dann $Q_e = q_{k+1}'$. und die noch verbleibende Zeit bis zum Erreichen des Entladeschlusskriteriums bei dem vorgegebenen Entladestrom $I_{Batt,entl}$ ist $t_e = t_{k+1}'$.

In den Blöcken 11 bis 15 werden die stationäre Durchtrittspolarisation $U_D(I_{Batt,entl}, T_{Batt,entl})$, die Ruhespannung $U_{C0,k+1}'$, die Konzentrationspolarisation $U_{k,k+1}'$, die Elekt-rolytspannung $U_{e,k+1}'$, der Wert $\Delta U_{Nernst,k+1}'$, der ohmsche Spannungsabfall $U_{Ri,k+1}'$ und die Batteriespannung $U_{Batt,k+1}'$ berechnet. Die Gleichungen lauten dabei im einzelnen:

$$U_{C0,k+1}' = U_{C0,0}' + q_{k+1}' / C_0'$$

Startwerte: $U_{C0,0}' = U_{C0}, C_0' = C_0$

$$U_{k,k+1}' = U_{k,k}' + (I_{Batt,entl} * R_k(U_{C0,k+1}', T_{Batt,entl}) - U_{k,k}') * t_{sample}/tau_k$$

$$U_{e,k+1}' = U_{C0,k+1}' + U_{k,k+1}'$$

$$\Delta U_{Nernst,k+1}' = alpha * exp(-(U_{e,k+1}' - U_{ekn})/epsilon) + TK_{U00} * (T_{Batt,entl} - 25°C)$$

$$\text{Startwerte: } U_{k0}' = U_k, \quad R_{k025}' = R_{k025}$$

$$U_{Ri,k+1}' = R_i(U_{C0,k+1}', U_{C0,k+1}', T_{Batt,entl}) * I_{Batt,entl}$$

$$\text{Startwerte: } R_{i025}' = R_{i025}, U_{e,grenz}' = U_{e,grenz}$$

$$U_{Batt,k+1}' = U_{Ri,k+1}' + U_{e,k+1}' + {}^o U_{Nernst,k+1}' + U_D'$$

Dabei ist $U_{Batt,k+1}'$ mit dem Index k+1 ein neuer Wert nach einer Iteration. Die Iteration wird solange durchgeführt, bis ein vorgegebenes Entladeschlusskriterium, im vorliegenden Beispiel drei unterschiedliche Entladeschlusskriterien gleichzeitig, erfüllt sind.

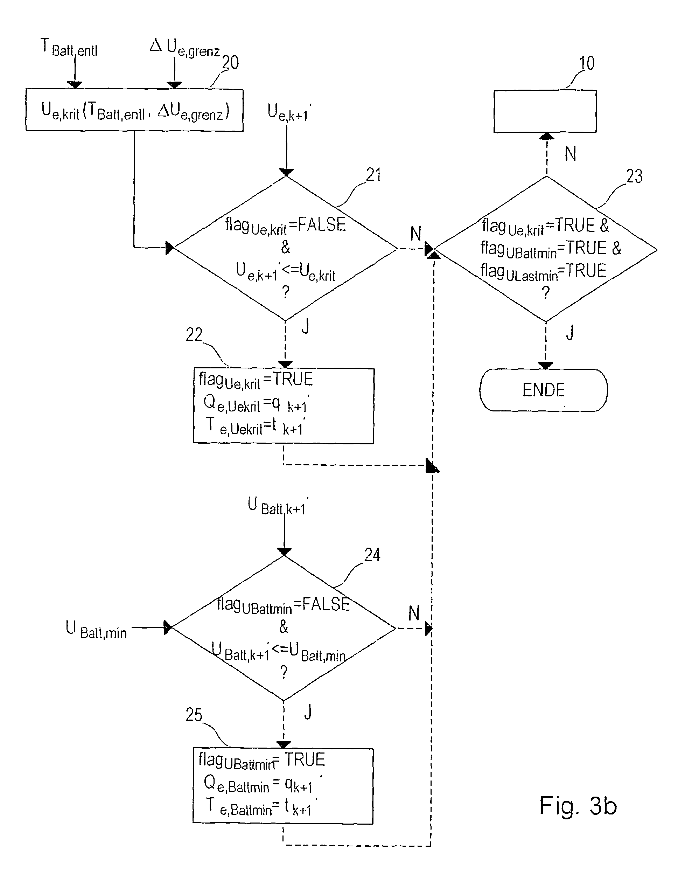

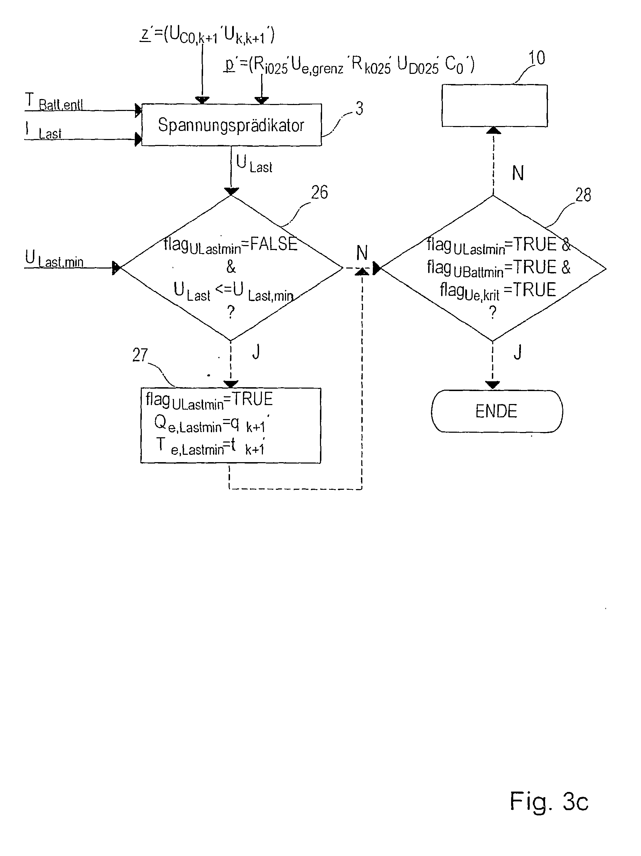

Der Vergleich der Zustandsgrößen mit den verschiedenen Entladeschlusskriterien ist in den Fig. 3b und 3c dargestellt. Das erste Entladeschlusskriterium.ist das Erreichen einer kritischen Elektrolytspannung $U_{e,krit}$, die von der Säurekonzentration im Elektrolyt, der Batterietemperatur $T_{Batt,entl}$ und einer Spannungsbegrenzung durch Aktivmasseverlust der Batterieelektroden $\Delta U_{e,grenz}$ bestimmt ist. In Schritt 21 von Fig. 3b wird für jeden Iterationsschritt k überprüft, ob die Elektrolytspannung $U_{e,k+1}'$ kleiner oder gleich der kritischen Elektrolytspannung ist. Falls ja, wird in Schritt 22 ein entsprechendes Flag $flag_{Ue,krit}$ auf logisch "1" (TRUE) gesetzt. Die entnehmbare Ladung $Q_e$ bei diesem Entladeschlusskriterium ist daher $Q_{e,Uekrit} = q_{k+1}'$ und die Zeitdauer bis zum Erreichen des Entladeschlusskriteriums ist $t_{e,Uekrit} = t_{k+1}'$.

In Schritt 24 wird, vorzugsweise parallel zu Schritt 21, überprüft, ob ein zweites Entladeschlusskriterium erreicht wurde. Dabei wird überprüft, ob die Batteriespannung $U_{Batt,k+1}'$ kleiner oder gleich einer vorgegebenen minimalen Batteriespannung $U_{Batt,min}$ ist. Falls ja, wird wiederum ein spezifisches Flag mit der Bezeichnung $flag_{UBattmin}$ auf TRUE gesetzt . Die entnehmbare Ladung $Q_{e,Ubattmin} = q_{k+1}'$, und die Zeit $t_{e,UBattmin}$ bis zum Erreichen dieses Entladeschlusskriteriums ist $t_{e,UBattmin} - t_{k+1}'$.

In Schritt 26 (siehe Fig. 3c) wird schließlich überprüft, ob das dritte Entladeschlusskriterium, nämlich eine erforderliche Mindestleistungsfähigkeit der Batterie, erreicht wurde. Hierbei wird überprüft, ob eine an einer vorgebbaren Last abfallende Lastspannung $U_{Last}$ während eines vorgegebenen Laststromverlaufs $I_{Last}$ kleiner oder gleich einer minimalen Lastspannung $U_{Last,min}$ werden würde, wenn die Last zu einem vorgebbaren Zeitpunkt eingeschaltet werden würde. Die Lastspannung $U_{Last}$ ist also diejenige Spannung, die sich an der Last oder z.B. an der Batterie einstellt, wenn die Last mit einem vorgegebenen Laststromverlauf $I_{Last}$ für eine vorgegebene Zeit $t_{Last}$ eingeschaltet werden würde. Diese Berechnung hat den Hintergrund, dass für die Zeitdauer $t_{Last}$ sichergestellt sein soll, dass die Netzspannung (oder Lastspannung) nicht unter einen vorgegebenen Mindestwert sinkt und die Last während ihrer Betriebsdauer $t_{Last}$ ausreichend versorgt wird. Zur Berechnung der Lastspannung $U_{Last}$, die sich nach einer vorgegebenen Einschaltzeit $t_{Last}$ einstellt, ist der Spannungsprädiktor 3 vorgesehen. Dieser berechnet anhand der bekannten Modelle für die Zustandsgrößen $U_{C0}$, $U_k$, $U_e$, $\Delta U_{Nernst}$, $U_{Ri}$ und $U_D$ die Batteriespannung $U_{Batt}$ (Schritt 36) bei einem vorgegebenen Laststromverlauf $I_{Last}$ und über eine vorgegebene Last-Einschaltdauer $t_{Last}$. Der minimale Wert der Batteriespannung $U_{Batt}$ aus allen Iterationsschritten (Schritt 37) nach Ablauf der Last-Einschaltdauer $t_{Last}$ (Schritt 38) ist gleich der Lastspannung $U_{Last}$ (Schritt 39). Der Spannungsprädiktor 3 nutzt in den Blocks 30 bis 36 die gleichen Berechnungsmodelle wie der Ladungsprädiktor für die Berechnung der Batterie-Zustandsgrößen, mit dem Unterschied, dass der Berechnung ein Laststromverlauf $I_{Last}$ zugrunde gelegt wird. Der Laststromverlauf $I_{Last}$ ist z.B. der Strom, den eine Last, wie z.B. der Startermotor in einem Kfz zum Betrieb benötigt. Laststromverlauf $I_{Last}$ Einschaltdauer $t_{Last}$ können z.B. von einer Steuereinheit vorgegeben werden. Es gilt:

$$q_{k+1}'' = q_k'' + I_{Last} * t_{sample}$$

$$t_{k+1}'' = t_k'' + t_{sample}$$

In Block 26 wird die bei der Lastsimulation auftretende minimale Batteriespannung $U_{Last}$ mit einem Schwellenwert $U_{Last,min}$ verglichen und festgestellt, ob die minimale Lastspannung $U_{Last}$ kleiner oder gleich der Spannung $U_{Last,min}$ ist.

Die Berechnung der minimalen Spannung $U_{min}$ bei vorgegebenem Laststrom $I_{Last}$ durch den Spannungsprädiktor 3 wird in jedem Iterationsschritt des Ladungsprädiktors 2 durchgeführt. Wenn die Simulation ergibt, dass die Mindestleistungsfähigkeit erreicht ist ($U_{Last} <= U_{Last,min}$), so wird ein spezifisches Flag mit der Bezeichnung $flag_{ULastmin}$ auf TRUE gesetzt. Die entnehmbare Ladung $Q_e$ bis zu diesem 3. Entladeschlusskriterium ist:

$$Q_{e,ULastmin} = q_{k+1}'.$$

Bei dem vorgegebenen Entladestrom $I_{Batt,entl}$ wird die Mindestleistungsfähigkeit der Batterie in einer Zeit

$$t_{e,ULastmin} = t_{k+1}'$$

erreicht (Block 27).

Falls die Entladeschlusskriterien in den Schritten 21, 24 und 26 nicht erreicht worden sind, so wird, ebenso wie nach den Blöcken 22, 25 und 27, in Schritt 28 überprüft, ob alle drei Entladeschlusskriterien gleichzeitig erfüllt sind. Falls ja, wird der minimale Wert der entnehmbaren Ladungen $Q_{e,Uekrit}$, $Q_{e,UBattmin}$, $Q_{e,ULastmin}$ als maximal entnehmbare Ladung ausgegeben. Gleichzeitig kann auch die zugehörige Zeitdauer $t_e$ ausgegeben werden. Falls Nein, wird die Berechnung fortgesetzt.

Bei konstantem Entladestrom $I_{Batt,entl}$ = konstant und konstanter Temperatur $T_{Batt,entl}$ = konstant können die Zustandsgrößen $U_{c0}'$ und $U_k'$ sowie die Batteriespannung $U_{Batt}'$ auch analytisch berechnet werden, so dass die rechenzeitintensive iterative Berechnung nach Fig. 3a durch den Ladungsprädiktor 2 entfallen kann.

5. Festlegung des ersten Entladeschlusskriteriums

Die aus einer Batterie entnehmbare Ladung hängt im wesentlichen von der im Elektrolyt enthaltenen Säure ab. Daneben ist das Entladeende zweitens auch abhängig von der beim Entladevorgang zugänglichen Aktivmasse (Pb, $PbO_2$ bei Bleiakkumulatoren) in den Elektroden der Batterie und drittens der Elektrolytvereisung bei niedrigen Temperaturen. Die Genauigkeit der entnehmbaren Ladung kann unter Berücksichtigung wenigstens eines der vorstehend genannten Effekte wesentlich verbessert werden.

5.1. Säurebegrenzung

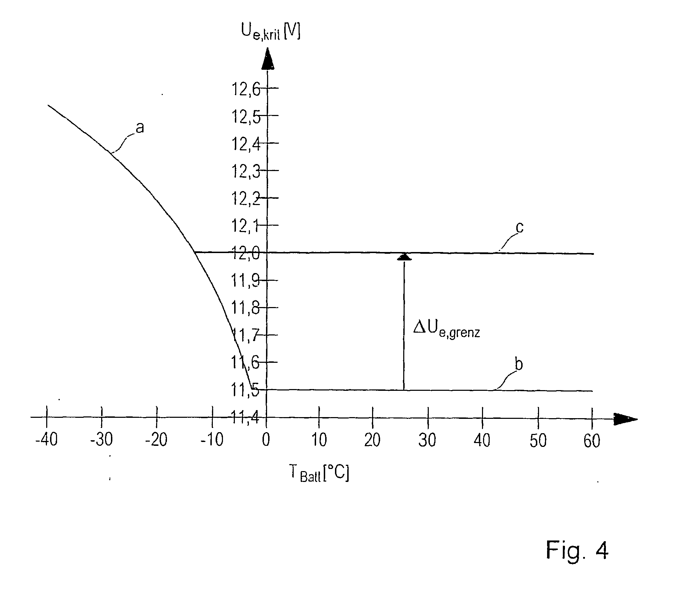

Bei neuen Batterien und Batterien mit geringem Aktivmasseverlust ist die Entladung der Batterie im wesentlichen durch die im Elektrolyt enthaltene Säure begrenzt (Säurebegrenzung). Bei der Berechnung der entnehmbaren Ladung durch den Ladungsprädiktor wird für die Säurekonzentration am Reaktionsort, (Elektroden) die hierzu proportionale Elektrolytspannung $U_e$ verwendet. Typische Grenzwerte für neue Batterien sind z.B. $U_{e,krit}$, Säure = 11,5 V bei Entladeende (siehe Ast b in Fig. 4).

## 5.2. Aktivmassebegrenzung

Bei Batterien mit höherem Aktivmasseverlust tritt das Entladeende (die Batterie liefert keine Ladung mehr) durch Verarmung der für die Entladereaktion zur Verfügung stehenden Aktivmasse ($Pb, PbO_2$) bereits bei höheren Spannungen ein. Fig. 4 zeigt diese Verschiebung der kritischen Elektrolytspannung $U_{e,krit}$ um einen Wert $\Delta U_{e,grenz}$ hin zu höheren Spannungen (von 11,5 auf 12V; von Ast b nach Ast c). Unter Berücksichtigung der Aktivmassebegrenzung kann daher folgende Beziehung angesetzt werden:

$$U_{e,krit,Masse} = 11,5 \; V + \Delta U_{e,grenz}$$

## 5.3. Elektrolytvereisung

Bei Temperaturen von weniger als -10°C kann, insbesondere bei niedriger Säurekonzentration, eine Elektrolytvereisung auftreten. Dabei wird die Zufuhr von Säure zum Reaktionsort an den Elektroden gehemmt, so dass eine niedrigere Säurenkonzentration an den Elektroden vorliegt (siehe Ast a in Fig. 4). Für die kritische Elektrolytspannung kann dabei folgende temperaturabhängige Beziehung angesetzt werden:

$$U_{e,krit,Eis}(T_{Batt}) = 11,423V - 0,0558V * (T_{Batt}/°C) - 0,0011V * (T_{Batt}/°C)^2 - 1,0*e-5V*(T_{Batt}/°C)^3$$

Unter Berücksichtigung aller drei Effekte kann für das erste Entladeschlusskriterium (Erreichen einer minimalen Elektrolytspannung $U_e$) folgende Beziehung verwendet werden:

$$U_e = U_{e,krit} = max(U_{e,krit,Säure}, U_{e,krit,Masse}, U_{e,krit,Eis})$$

Fig. 4 zeigt nochmals den resultierenden Verlauf der kritischen Elektrolytspannung $U_{e,krit}$ in Abhängigkeit von der Batterietemperatur $T_{Batt}$ und $\Delta U_{e,grenz}$.

Bezugszeichenliste

| | |
|---|---|
| 1 | Zustandsgrößen- und Parameterschätzer |
| 2 | Ladungsprädiktor |
| 3 | Spannungsprädiktor |
| 10-15 | Berechnungsschritte des Ladungsprädiktors |
| 20-28 | Überprüfung des Entladeschlusses |
| 30-39 . | Berechnungsschritte des Spannungsprädiktors |
| Z | Zustandsgrößen |
| P | Parameter |
| $U_{Batt}$ | Batteriespannung |
| $I_{Batt}$ | Batteriestrom |
| $T_{Batt}$ | Batterietemperatur |
| $I_{Batt,entl}$ | Entladestromverlauf |
| $T_{Batt,entl}$ | Temperaturverlauf |
| $Q_{e,ue,krit}$ | entnehmbare Ladung bis zum Erreichen der Kritischen Elektrolytspannung |
| $Q_{e,UBattmin}$ | entnehmbare Ladung bis zum Erreichen der Minimalen Batteriespannung |
| $Q_{e,ULastmin}$ | entnehmbare Ladung bis zum Erreichen der Mindestleistungsfähigkeit |
| $t_e$ | Zeitdauer bis zum Erreichen des Entladeschlusses |

| | |
|---|---|
| $I_{Last}$ | Laststrom |
| $U_{Last}$ | Lastspannung |
| $R_i$ | ohmscher Innenwiderstand |
| $U_{C0}$ | Ruhespannung |
| $U_k$ | Konzentrationspolarisation |
| $U_{Ri}$ | Spannungsabfall am ohmschen Widerstand |
| $R_k$ | Säurediffusionswiderstand |
| $\Delta U_{Nernst}$: | Spannungsdifferenz zwischen Elektrodenpotential und Elektrolytspannung |
| $U_e$ | Elektrolytspannung |
| $U_D$ | Durchtrittspolarisation |
| $U_{e,krit}$ | kritische Elektrolytspannung |
| $U_{Batt,min}$ | minimale Batteriespannung |
| $U_{Last,min}$ | minimale Lastspannung |

**Patentansprüche**

1. Vorrichtung zum Ermitteln der aus einem Energiespeicher, insbesondere einer Batterie, bis zu einem vorgegebenen Entladeschluss entnehmbaren Ladung ($Q_e$), **gekennzeichnet durch**

   - einen Ladungsprädiktor (2), der die bei einem vorgegebenen Entladestromverlauf ($_{IBatt,entl}$) aus dem Energiespeicher entnehmbare Ladung ($Q_e$) auf der Grundlage eines mathematischen Energiespeichermodells berechnet, das die elektrischen Eigenschaften des Energiespeichers mathematisch darstellt, und
   - einen Zustandsgrößen- und Parameterschätzer (1), der aus aktuellen Betriebsgrößen ($U_{Batt}$, $I_{Batt}$, $T_{Batt}$) des Energiespeichers Zustandsgrößen (Z) und/oder Parameter (P) für das mathematische Energiespeichermodell ermittelt, wobei der Ladungsprädiktor (2) die entnehmbare Ladung (Ge) bis zum Erreichen eines vorgegebenen Entladeschlusskriteriums ($U_{emin,}$ $U_{Battmin}$, $U_{Lastmin}$) ermittelt.

2. Vorrichtung nach Anspruch 1, **dadurch gekennzeichnet, dass** das Energiespeichermodell ein Batteriemodell ist, das wenigstens ein mathematisches Modell für den Innenwiderstand ($R_i$), einen Säurediffusionswiderstand ($R_k$) und eine Durchtrittspolarisation ($U_D$) umfasst.

3. Vorrichtung nach Anspruch 1 oder 2, **dadurch gekennzeichnet, dass** der Zustandsgrößen- und Parameterschätzer (1) als Zustandsgrößen (Z) wenigstens eine Ruhespannung ($U_{C0}$) und eine Konzentrationspolarisation ($U_k$) vermittelt.

4. Vorrichtung nach Anspruch 3, **dadurch gekennzeichnet, dass** der Zustandsgrößen- und Parameterschätzer (1) ferner eine Durchtrittspolarisation ($U_D$) ermittelt.

5. Vorrichtung nach einem der vorhergehenden Ansprüchen, **dadurch gekennzeichnet, dass** der Ladungsprädiktor (2) die entnehmbare Ladung ($Q_e$) bis zum Erreichen einer vorgegebenen minimalen Elektrolytspannung ($U_{emin}$) ermittelt, die ein erstes Entladeschlusskriterium darstellt.

6. Vorrichtung nach einem der vorhergehenden Ansprüchen, **dadurch gekennzeichnet, dass** der Ladungsprädiktor (2) die entnehmbare Ladung ($Q_e$) bis zum Erreichen einer minimalen Spannung ($U_{Battmin}$) des Energiespeichers ermittelt, die ein zweites Entladeschlusskriterium darstellt.

7. Vorrichtung nach einem der vorhergehenden Ansprüchen, **dadurch gekennzeichnet, dass** der Ladungsprädiktor (2) die entnehmbare Ladung ($Q_e$) bis zum Erreichen einer vorgegebenen Mindestleistungsfähigkeit ($U_{Lastmin}$) ermittelt, die ein drittes Entladeschlusskriterium darstellt.

8. Vorrichtung nach einem der vorhergehenden Ansprüchen, **dadurch gekennzeichnet, dass** ein Spannungsprädiktor vorgesehen ist, dem ein Laststromverlauf ($I_{Last}$) vorgebbar ist und der in Abhängigkeit vom Laststrom ($I_{Last}$) eine zugehörige Lastspannung ($U_{Last}$) ermittelt, die sich aufgrund des vorgegebenen Laststromverlaufs ($I_{Last}$) einstellen würde.

9. Verfahren zum Ermitteln der aus einem Energiespeicher, insbesondere einer Batterie, bis zu einem vorgegebenen Entladeschluss entnehmbaren Ladung ($Q_e$), **gekennzeichnet durch** folgende Schritte:

- Berechnen der bei einem vorgegebenen Entladestromverlauf ($I_{Batt,Entlade}$) aus dem Energiespeicher entnehmbaren Ladung ($Q_e$) mit Hilfe eines Ladungsprädiktors (2) auf der Grundlage eines mathematischen Energiespeichermodells, das die elektrischen Eigenschaften des Energiespeichers mathematisch darstellt, und

- Ermitteln von Zustandsgrößen (Z) und/oder Parametern (P) für das mathematische Energiespeichermodell aus aktuellen Betriebsgrößen ($U_{Batt}$, $I_{Batt}$, $T_{Batt}$) des Energiespeichers mit Hilfe eines Zustandsgrößen- und Parameterschätzers (1), wobei **durch** den Ladungsprädiktor (2) die entnehmbare Ladung ($Q_e$) bis zum Erreichen eines vorgegebenen Entladeschlusskriteriums ($U_{emin}$, $U_{Battmin}$ ($U_{Lastmin}$) ermittelt wird.

10. Verfahren nach Anspruch 9, **dadurch gekennzeichnet, dass** der Ladungsprädiktor (2) eine bis zum Erreichen einer vorgegebenen Mindestleistungsfähigkeit ($U_{Lastmin}$) entnehmbare Ladung ($Q_e$) berechnet, wobei eine Lastspannung ($U_{Last}$) berücksichtigt wird, die dem Ladungsprädiktor (2) von einem Spannungsprädiktor (1) zugeführt wird, der die Lastspannung ($U_{Last}$) in Abhängigkeit von einem vorgegebenen Laststromverlauf ($I_{Last}$) ermittelt.

**Claims**

1. Apparatus for determination of the charge ($Q_e$) which can be drawn from an energy store, in particular from a battery, before a predetermined discharge conclusion, **characterized by**

   - a charge predictor (2) which calculates the charge ($Q_e$) which can be drawn from the energy store with a predetermined discharge current profile ($I_{Batt,disch}$) on the basis of a mathematical energy store model which mathematically represents the electrical characteristics of the energy store, and
   - a state-variable and parameter estimator (1) which determines state variables (Z) and/or parameters (P) for the mathematical energy store model from instantaneous operating variables ($U_{Batt}$, $I_{Batt}$, $T_{Batt}$) of the energy store, wherein the charge predictor (2) determines the charge ($Q_e$) which can be drawn before a predetermined discharge conclusion criterion ($U_{emin}$, $U_{Battmin}$, $U_{Loadmin}$) is reached.

2. Apparatus according to Claim 1, **characterized in that** the energy store model is a battery model which comprises at least one mathematical model for the internal resistance ($R_i$), an acid diffusion resistance ($R_k$) and a forward-flow polarization ($U_D$).

3. Apparatus according to Claim 1 or 2, **characterized in that** the state-variable and parameter estimator (1) determines at least one rest voltage ($U_{C0}$) and one concentration polarization ($U_k$) as state variables (Z).

4. Apparatus according to Claim 3, **characterized in that** the state-variable and parameter estimator (1) furthermore determines a forward-flow polarization ($U_D$).

5. Apparatus according to one of the preceding claims, **characterized in that** the charge predictor (2) determines the charge ($Q_e$) which can be drawn before a predetermined minimum electrolyte voltage ($U_{emin}$) is reached, which minimum electrolyte voltage ($U_{emin}$) represents a first discharge conclusion criterion.

6. Apparatus according to one of the preceding claims, **characterized in that** the charge predictor (2) determines the charge ($Q_e$) which can be drawn before a minimum voltage ($U_{Battmin}$) of the energy store is reached, which minimum voltage ($U_{Battmin}$) represents a second discharge conclusion criterion.

7. Apparatus according to one of the preceding claims, **characterized in that** the charge predictor (2) determines the charge ($Q_e$) which can be drawn before a predetermined minimum power capability ($U_{Loadmin}$) is reached, which minimum power capability ($U_{Loadmin}$) represents a third discharge conclusion criterion.

8. Apparatus according to one of the preceding claims, **characterized in that** a voltage predictor is provided, for which a load current profile ($I_{Load}$) can be predetermined and which determines an associated load voltage ($U_{Load}$) as a function of the load current ($I_{Load}$), which load voltage ($U_{Load}$) would result from the predetermined load current profile ($I_{Load}$) .

9. Method for determination of the charge ($Q_e$) which can be drawn from an energy store, in particular from a battery, before a predetermined discharge conclusion, **characterized by** the following steps:

   - calculation of the charge ($Q_e$) which can be drawn from the energy store with a predetermined discharge current profile ($I_{Batt,disch}$) with the aid of a charge predictor (2) on the basis of a mathematical energy store model which mathematically represents the electrical characteristics of the energy store, and
- determination of state variables (Z) and/or parameters (P) for the mathematical energy store model from instantaneous operating variables ($U_{Batt}$, $I_{Batt}$, $T_{Batt}$) of the energy store with the aid of a state-variable and parameter estimator (1), wherein the charge ($Q_e$) which can be drawn before a predetermined discharge conclusion criterion ($U_{emin}$, $U_{Battmint}$ $U_{Loadmin}$) is reached is determined by the charge predictor (2).

10. Method according to Claim 9, **characterized in that** the charge predictor (2) calculates a charge ($Q_e$) which can be drawn before a predetermined minimum power capability ($U_{Loadmin}$) is reached, with a load voltage ($U_{Load}$) being taken into account, which is supplied to the charge predictor (2) from a voltage predictor (1) which determines the load voltage ($U_{Load}$) as a function of a predetermined load current profile ($I_{Load}$).

## Revendications

1. Dispositif de détermination de la charge ($Q_e$) prélevée sur un accumulateur d'énergie et en particulier sur une batterie jusqu'à une fin prédéterminée de la décharge,
**caractérisé par**

- un prédicteur de charge (2) qui calcule la charge ($Q_e$) qui peut être prélevée sur l'accumulateur d'énergie pour une évolution prédéterminée du courant de décharge ($I_{Batt, Entl}$), sur base d'un modèle mathématique de l'accumulateur d'énergie qui représente mathématiquement les propriétés électriques de l'accumulateur d'énergie et
- un estimateur (1) de grandeurs d'état et de paramètres qui détermine à partir de grandeurs effectives de fonctionnement ($U_{Batt}$, $I_{Batt}$, $T_{Batt}$) de l'accumulateur d'énergie des grandeurs d'état (Z) et/ou des paramètres (P) pour le modèle mathématique de l'accumulateur d'énergie,

le prédicteur de charge (2) déterminant la charge ($Q_e$) qui peut être prélevée jusqu'à atteindre un critère prédéterminé de fin de décharge ($U_{emin}$, $U_{Battmin}$, $U_{Lastmin}$) .

2. Dispositif selon la revendication 1, **caractérisé en ce que** le modèle de l'accumulateur d'énergie est un modèle de batterie qui comprend au moins un modèle mathématique de la résistance interne ($R_i$), d'une résistance ($R_k$) à la diffusion d'acide et d'une polarisation de passage ($U_D$).

3. Dispositif selon les revendications 1 ou 2, **caractérisé en ce que** l'estimateur (1) de grandeurs d'état et de paramètres détermine comme grandeurs d'état (Z) au moins une tension au repos ($U_{C0}$) et une polarisation de concentration ($U_k$).

4. Dispositif selon la revendication 3, **caractérisé en ce que** l'estimateur (1) de grandeurs d'état et de paramètres détermine en outre une polarisation de passage ($U_D$).

5. Dispositif selon l'une des revendications précédentes, **caractérisé en ce que** le prédicteur de charge (2) détermine la charge ($Q_e$) que l'on peut prélever jusqu'à atteindre une tension minimale prédéterminée dans l'électrolyte ($U_{emin}$), qui représente un premier critère de fin de décharge.

6. Dispositif selon l'une des revendications précédentes, **caractérisé en ce que** le prédicteur de charge (2) détermine la charge ($Q_e$) qui peut être prélevée jusqu'à atteindre une tension minimale ($U_{Battmin}$) de l'accumulateur d'énergie, qui représente un deuxième critère de fin de décharge.

7. Dispositif selon l'une des revendications précédentes, **caractérisé en ce que** le prédicteur de charge (2) détermine la charge ($Q_e$) qui peut être prélevée jusqu'à atteindre une capacité prédéterminée de puissance minimale ($U_{Lastmin}$), qui constitue un troisième critère de fin de décharge.

8. Dispositif selon l'une des revendications précédentes, **caractérisé en ce qu'**il présente un prédicteur de tension auquel une évolution du courant de décharge ($I_{Last}$) peut être appliquée et qui, en fonction du courant de charge ($I_{Last}$), détermine la tension de charge ($U_{Last}$) associée qui se serait établie du fait de l'évolution prédéterminée du courant de charge ($I_{Last}$).

9. Procédé de détermination de la charge ($Q_e$) qui peut être prélevée sur un accumulateur d'énergie et en particulier sur une batterie jusqu'à une fin prédéterminée de décharge,
**caractérisé par** les étapes suivantes :

- calcul de la charge ($Q_e$) qui peut être prélevée sur l'accumulateur d'énergie pour une évolution prédéterminée du courant de décharge ($I_{Batt, Entlade}$), à l'aide d'un prédicteur de charge (2) qui travaille sur base d'un modèle mathématique de l'accumulateur d'énergie qui représente mathématiquement les propriétés électriques de l'accumulateur d'énergie et
- détermination de grandeurs d'état (Z) et/ou de paramètres (P) pour le modèle mathématique de l'accumulateur d'énergie à partir de grandeurs effectives de fonctionnement ($U_{Batt}$, $I_{Batt}$, $T_{Batt}$) de l'accumulateur d'énergie, à l'aide d'un estimateur (1) de grandeurs d'état et de paramètres, la charge ($Q_e$) qui peut être prélevée jusqu'à atteindre un critère prédéterminé de fin de décharge ($U_{emin}$, $U_{Battmim}$ $U_{Lastmin}$) étant déterminée par le prédicteur de charge (2).

10. Procédé selon la revendication 9, **caractérisé en ce que** le prédicteur de charge (2) calcule la charge ($Q_e$) qui peut être prélevée jusqu'à atteindre une capacité prédéterminée de puissance minimale ($U_{Lastmin}$) en tenant compte d'une tension de charge ($U_{Last}$) qui est amenée au prédicteur de charge (2) par un prédicteur de tension (1) qui détermine la tension de charge ($U_{Last}$) en fonction d'une évolution prédéterminée du courant de charge ($I_{Last}$).

U $_{Batt}$
I $_{Batt}$
T $_{Batt}$

1

z

P

2

z′

P′

I $_{Batt,entl}$

T $_{Batt,entl}$

U $_{Batt}$′

t $_{e}$, Q $_{e,Uekrit}$

t $_{e}$, Q $_{e,UBattmin}$

t $_{e}$, Q $_{e,ULastmin}$

3

U $_{Last}$

I $_{Last}$

Fig. 1

$R_i (U_{co}, U_e, T_{Batt})$    $R_k (U_{co}, T_{Batt})$

$C_o$

$C_k$

$I_{Batt}$

$U_{RI}$    $U_{co}$    $U_k$    $\Delta U_{Nernst} (U_B, T_{Batt})$    $U_D (I_{Batt}, T_{Batt})$

$U_e$

$U_{Batt}$

Fig. 2

Fig. 3a

$T_{Batt,entl}$     $\Delta U_{e,grenz}$   20

$U_{e,krit}(T_{Batt,entl}, \Delta U_{e,grenz})$

$U_{e,k+1}'$

10

21

flag$_{Ue,krit}$=FALSE
&
$U_{e,k+1}' <= U_{e,krit}$
?

N

23

flag$_{Ue,krit}$=TRUE &
flag$_{UBattmin}$=TRUE &
flag$_{ULastmin}$=TRUE
?

N

J

22

flag$_{Ue,krit}$=TRUE
$Q_{e,Uekrit}=q_{k+1}'$
$T_{e,Uekrit}=t_{k+1}'$

ENDE

$U_{Batt,k+1}'$

24

flag$_{UBattmin}$=FALSE
&
$U_{Batt,k+1}' <= U_{Batt,min}$
?

N

$U_{Batt,min}$

J

25

flag$_{UBattmin}$= TRUE
$Q_{e,Battmin}= q_{k+1}'$
$T_{e,Battmin}= t_{k+1}'$

Fig. 3b

$$\underline{z}' = (U_{C0,k+1}' \ U_{k,k+1}')$$

$$\underline{p}' = (R_{i025}' \ U_{e,grenz}' \ R_{k025}' \ U_{D025}' \ C_0')$$

$T_{Batt,entl}$

$I_{Last}$

Spannungsprädikator — 3

$U_{Last}$

26

flag$_{ULastmin}$=FALSE
&
$U_{Last} <= U_{Last,min}$
?

$U_{Last,min}$

N

28

flag$_{ULastmin}$=TRUE &
flag$_{UBattmin}$=TRUE &
flag$_{Ue,krit}$=TRUE
?

10

N

J

27

flag$_{ULastmin}$=TRUE
$Q_{e,Lastmin} = q_{k+1}'$
$T_{e,Lastmin} = t_{k+1}'$

J

ENDE

Fig. 3c

$I_{Batt,entl}(t)$

$T_{Batt,entl}(t)$

**30**
$$q_{k+1}'' = q_k'' + I_{Last} * t_{sample}$$
$$t_{k+1}'' = t_k'' + t_{sample}$$
$$q_0'' = 0, \quad t_0'' = 0$$

**31**
$$U_D(I_{Last}, T_{Batt,entl})$$
$$U_{D025}'' = U_{D025}'$$

$q_{k+1}''$

$U_D''$

**32**
$$U_{C0,k+1}'' = U_{C0,0}'' + q_{k+1}''/C_0''$$
$$U_{C0,0}'' = U_{C0}', \quad C_0'' = C_0'$$

$U_{C0,k+1}''$ **33**

$$U_{k,k+1}'' = U_{k,k}'' + (I_{Last} * R_k(U_{C0,k+1}'', T_{Batt,entl}) - U_{k,k}'') * t_{sample}/T_k$$

$$U_{e,k+1}'' = U_{C0,k+1}'' + U_{k,k+1}''$$

$$\Delta U_{Nernst,k+1}'' = alpha * exp(-(U_{e,k+1}'' + U_{ekn})/beta) + TK_{U00} * (T_{Batt,entl} - 25°C)$$

$$U_{k,0}'' = U_k', \quad R_{k025}'' = R_{k025}'$$

$U_{e,k+1}''$ **34**

$\Delta U_{Nernst,k+1}''$

$$U_{Ri,k+1}'' = R_i(U_{C0,k+1}'', U_{e,k+1}'', T_{Batt,entl}) * I_{Batt,entl}$$
$$R_{i025}'' = R_{i025}', \quad U_{e,grenz}'' = U_{e,grenz}'$$

$U_{Ri,k+1}''$

**N**

**37**
$$t_{k+1}'' >= t_{Last}?$$

**J**

**38**
$$U_{Last} = U_{min}$$

**35**
$$U_{Batt,k+1}'' = U_{Ri,k+1}'' + U_{e,k+1}'' + \Delta U_{Nernst,k+1}'' + U_D''$$

$U_{Batt,k+1}''$

**36**
$$U_{min} = min(U_{Batt,k+1}'')$$

Fig. 3d

Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0376967 B1
- WO 9013823 A
- DE 10203810 A1
- EP 420530 A1

**In der Beschreibung aufgeführte Nicht-Patentliteratur**

- **S. Piller ; M.Perrin ; A.Jossen.** Methods for state-of-charge determination and their applications. *Journal of Power Sources,* 2001, vol. 96, 113-120